# EUROPÄISCHE PATENTANMELDUNG

(11) **EP 1 808 702 A1**
(43) Veröffentlichungstag der Anmeldung: **18.07.2007**
(21) Anmeldenummer: 07000184.7
(22) Anmeldetag: 05.01.2007
(51) Int. Cl.: G01R 27/28

(54) **Netzwerkanalysator und Verfahren zur Regelung eines Pegels eines Signals im Netzwerkanalysator**

(30) Priorität: 11.01.2006 DE 102006001477
(71) Anmelder: Rohde & Schwarz GmbH & Co. KG, 81671 München (DE)
(72) Erfinder: Held, Werner, 94060 Pocking (DE)
(74) Vertreter: Körfer, Thomas

(57) **Zusammenfassung**

Es wird ein Verfahren zur Regelung eines Signalpegels eines Signals (32,34) an einem Netzwerkanalysator (1,62), womit ein Anregungssignal (18) zum Analysieren eines am Netzwerkanalysator (1,62) anschließbaren Meßobjekts (2) erzeugt wird, angegeben, bei welchem ein dem Anregungssignal (18) entsprechendes Referenzsignal (24,26) auf einen Referenzzweig (28,30) ausgekoppelt und ein Referenzsignalpegel des Referenzsignals (24,26) ermittelt und/oder ein vom Meßobjekt (2) rücklaufendes Meßsignal (32,34) auf einen Meßzweig (36,38) ausgekoppelt und ein Meßsignalpegel des Meßsignals (32,34) ermittelt und bei Überschreiten einer spezifischen Pegelobergrenze und/oder bei Unterschreiten einer spezifischen Pegeluntergrenze erniedrigt bzw. erhöht wird. Des Weiteren wird ein Netzwerkanalysator (1,62) zur Durchführung des Verfahrens angegeben.

## Beschreibung

Die Erfindung bezieht sich auf einen Netzwerkanalysator und ein Verfahren zur Regelung eines Signalpegels eines Signals in dem Netzwerkanalysator.

Zur Analyse eines Meßobjekts wird von einem Netzwerkanalysator ein Anregungssignal zur Verfügung gestellt. Das Anregungssignal wird über Tore des Meßobjekts diesem zugeführt. Beispielsweise zur Ermittlung eines Eingangsreflexionsfaktors und eines Vorwärtsübertragungsfaktors sowie eines Ausgangsreflexionsfaktors und eines Rückwärtsübertragungsfaktors wird das Anregungssignal dem Meßobjekt, welches ein Eingangstor und ein Ausgangstor aufweist, am Eingangstor oder am Ausgangstor angelegt. Zur Ermittlung der Reflexionsfaktoren und der Übertragungsfaktoren ist am Eingangs- und/oder Ausgangstor des Meßobjekts jeweils die einfallende als auch die rücklaufende Welle des Anregungssignals zu erfassen. Um zu ermitteln, bei welchem Frequenzbereich das Anregungssignal das Meßobjekt passiert und bei welchem Frequenzbereich das Anregungssignals an einem Tor des Meßobjekts reflektiert wird, fährt der Netzwerkanalysator in einem Frequenz-Sweep die Frequenz des Anregungssignals durch einen vorgegebenen Frequenzbereich.

Ein Netzwerkanalysator dieser Art ist z. B. aus der DE 102 46 700 A1 bekannt.

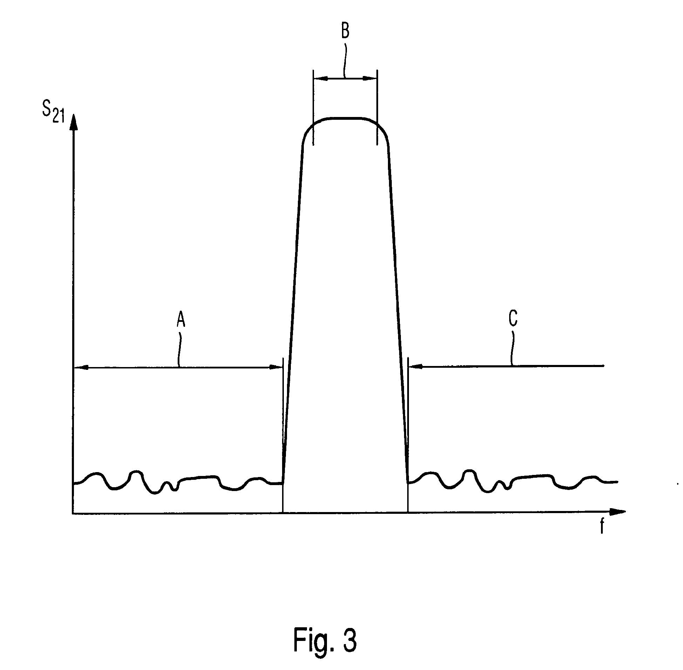

In Fig. 3 ist der Torparameter "Vorwärtsübertragungsfaktor s₂₁" des als Bandpaß ausgeführten Meßobjekts über die Frequenz gezeigt. Der Torparameter s₂₁ beschreibt das Verhältnis der am Ausgangstor des Meßobjekt rücklaufende Welle b₂ zu der am Eingangstor einfallenden Welle a₁ des Anregungssignals. Das Anregungssignal wird am Eingangstor des Bandpasses im Frequenzbereich A sowie im Frequenzbereich C reflektiert. Im Frequenzbereich B transmittiert das Anregungssignal durch den Bandpaß.

Bei einem gewöhnlichen Netzwerkanalysator ist ein Übergang zwischen den im Weiteren als Sperrbereiche bezeichneten Frequenzbereichen A und C in den im Weiteren als Durchlaßbereich bezeichneten Frequenzbereich B vergleichsweise ungenau meßbar. Außerdem ist der Frequenzbereich, bei welchem der jeweilige Übergang erfolgt, lediglich ungenau und nicht ohne weiteres feststellbar. Dies liegt zum einen daran, dass eine Minimaltransmission des Anregungssignals durch das Meßobjekt in dessen Sperrbereich vom Eigenrauschen der Meßleitungen, welche den Netzwerkanalysator mit dem Meßobjekt verbinden, nicht unterscheidbar und somit nicht meßbar ist. Dies liegt zum anderen auch daran, dass eine die Meßsignale empfangende Einrichtung des Netzwerkanalysators aufgrund eines vergleichsweise hohen Signalpegels der Meßsignale übersteuert sein kann.

Bei der Analyse des Meßobjekt stößt der gewöhnliche Netzwerkanalysator somit schnell an seine Grenzen, da eine 'minimale' Transmission des Anregungssignals durch das Meßobjekt aufgrund des Eigenrauschens der Meßleitungen und eine 'maximale' Transmission aufgrund einer Übersteuerung der die Meßsignale empfangenden Einrichtung nicht meßbar sind. Die Dynamik des gewöhnlichen Netzwerkanalysators, unter welcher das Verhältnis von minimal zu maximal meßbarer Transmission zu verstehen ist, ist damit vergleichsweise klein.

Der Erfindung liegt die Aufgabe zu Grunde, ein Verfahren und eine Vorrichtung zur Regelung eines Signalpegels eines Signals anzugeben, welches zur Analyse eines an einem Netzwerkanalysator anschließbaren Meßobjekts verwendet wird und womit der Dynamikbereich des Netzwerkanalysators erweitert wird.

Bezüglich des Verfahrens wird die Aufgabe erfindungsgemäß gelöst durch die Merkmale des Anspruchs 1. Vorteilhafte Weiterbildungen sind Gegenstand der hierauf rückbezogenen Unteransprüche.

Bezüglich des Netzwerkanalysators wird die Aufgabe erfindungsgemäß gelöst durch die Merkmale des Anspruchs 7.

Vorteilhafte Weiterbildungen sind Gegenstand der hierauf rückbezogenen Unteransprüche.

So umfasst der Netzwerkanalysator einen Signalgenerator, womit ein Anregungssignal zur Analyse eines am Netzwerkanalysator anschließbaren Meßobjekts erzeugbar und über eine Meßleitung diesem zuführbar ist, sowie eine an der Meßleitung angeordnete Meßbrücke, worüber ein dem Anregungssignal entsprechendes Referenzsignal auf einen Referenzzweig und ein auf der Meßleitung vom Meßobjekt rücklaufendes Meßsignal auf einen Meßzweig auskoppelbar ist. Dabei umfasst der Netzwerkanalysator weiterhin einen an den Referenzzweig und den Meßzweig gekoppelten AD-Wandler (Analog/Digital-Wandler), welchem das Referenzsignal und das Meßsignal zugeführt werden. Eine mit dem AD-Wandler signalverbundene Auswerteeinrichtung ermittelt einen Referenzsignalpegel des Referenzsignals und/oder einen Meßsignalpegel des Meßsignals. Eine mit der Auswerteeinrichtung signalverbundene Steuereinrichtung steuert ein am Referenzzweig vorgesehenes Stellglied und/oder ein am Meßzweig vorgesehenes Stellglied in Abhängigkeit des Referenzsignalpegels und/oder des Meßsignalpegels an.

Unter dem Meßobjekt ist ein Vielpol mit einem oder mehreren Eingangstoren und einem oder mehreren Ausgangstoren zu verstehen. Zur Analyse des Vielpols ist dieser sowohl am Eingangstor als auch am Ausgangstor über die Meßleitung mit dem Netzwerkanalysator signalverbindbar. Das bedeutet, dass das Anregungssignal am Eingangstor sowie am Ausgangstor dem Vielpol zuführbar ist.

Das Verfahren zur Regelung eines Signalpegels eines Signals an dem Netzwerkanalysator umfasst zunächst die Ermittlung eines Referenzsignalpegels eines Referenzsignals, welches einem im Netzwerkanalysator erzeugten Anregungssignal zum Analysieren eines am Netzwerkanalysator anschließbaren Meßobjekts entspricht. Außerdem oder alternativ umfasst das Verfahren die Ermittlung eines Meßsignalpegels eines Meßsignals, welches vom Meßobjekt zurückläuft und auf einen Meßzweig ausgekoppelt wird.

In einem Fall wird zur Erhöhung der Meßgenauigkeit und zur Vermeidung einer Übersteuerung des A/D-Wandlers, welchem das Referenzsignal und das Meßsignal zugeführt werden, bei Überschreiten einer spezifischen Pegelobergrenze der Referenzsignalpegel und/oder der Meßsignalpegel erniedrigt. Im anderen Fall wird zur Erhöhung der Meßgenauigkeit bei Unterschreiten einer spezifischen Pegeluntergrenze der Referenzsignalpegel und/oder der Meßsignalpegel erhöht.

Dabei ist unter einer spezifischen Pegelobergrenze diejenige Pegelgrenze zu verstehen, bei welcher der A/D-Wandler, welchem das Referenzsignal und das Meßsignal zugeführt werden, bauelementspezifisch übersteuert werden würde. Ein dauerhaftes Überschreiten der Pegelobergrenze soll vermieden werden.

Weiter ist unter einer spezifischen Pegeluntergrenze diejenige funktionsspezifische Pegelgrenze zu verstehen, bei welcher das Referenzsignal und/oder das Meßsignal gerade noch von einem Eigenrauschen der das Referenzsignal und/oder das Meßsignal tragenden Referenzzweige bzw. Meßzweige sowie Meßleitungen unterscheidbar ist. Ein dauerhaftes Unterschreiten der Pegeluntergrenze soll vermieden werden.

Um den Vorwärtsübertragungsfaktor eines als Vielpol ausgebildeten Meßobjekts zu ermitteln, ist es erforderlich, das Verhältnis zwischen dem vom Ausgangstor des Vielpols rücklaufenden Signal zu dem am Eingangstor des Vielpols einfallenden Anregungssignal zu ermitteln. Befindet sich die Frequenz des Anregungssignals im Durchlaßbereich des Vielpols, sollte eine Übersteuerung des AD-Wandlers vermieden werden. Hierzu dient die bauelementspezifische Pegelobergrenze.

Weist der Vielpol bei einer Frequenz des Anregungssignals einen Sperrbereich auf, so wird mit Hilfe der funktionsspezifischen Pegeluntergrenze gewährleistet, dass der Meßsignalpegel des vom Ausgangstor des Vielpols rücklaufenden Meßsignals derart erhöht wird, dass ein vergleichsweise minimaler Anteil des Anregungssignals, welcher den Vielpol passiert hat und als Meßsignal vom Ausgangstor des Vielpols auf der Meßleitung zurückläuft, vom Eigenrauschen der Meßleitung unterscheidbar und damit meßbar ist.

Gemäß einer vorteilhaften Ausgestaltung werden der Referenzsignalpegel und der Meßsignalpegel mittels eines am Referenzzweig angeordneten Referenzzweigstellglieds bzw. mittels eines am Meßzweig angeordneten Meßzweigstellglieds eingestellt. Die getrennte Ausführung des Referenzzweigstellgliedes und des Meßzweigstellgliedes am Referenzzweig bzw. am Meßzweig ist besonders effizient dahingehend, dass der Pegel des Referenzsignals, welches dem zulaufenden Anregungssignal entspricht, unabhängig vom Pegel des Meßsignals, welches vom Meßobjekt zurückläuft, veränderbar ist.

Zur Einstellung eines Anregungssignalpegels des Anregungssignals, beispielsweise, um einer Schädigung des Meßobjekts vorzubeugen, ist es zweckmäßig, dem Signalgenerator ein Generatorstellglied auf der Signalleitung nachzuschalten. Dabei ist die Erfassung des Anregungsignalpegels über den Referenzzweig möglich, worüber das dem Anregungssignal entsprechende Referenzsignal ausgekoppelt wird.

Um eine besonders exakte Einstellung des jeweiligen Signalpegels zu gewährleisten, ist das jeweilige Stellglied als Dämpfungsglied oder als verstellbarer Verstärker ausgebildet. In zweckmäßiger Weiterbildung umfasst das Stellglied ein Dämpfungsglied und/oder einen verstellbaren Verstärker.

Um bei Veränderung lediglich des Referenzsignalpegels oder des Meßsignalpegels Torparameter des Meßobjekt, wie beispielsweise den Vorwärtsübertragungsfaktor, besonders korrekt bestimmen zu können, ist es zweckmäßig, die Veränderung des jeweiligen Signalpegels bei der Bestimmung der Torparameter zu berücksichtigen.

In zweckmäßiger Weiterbildung ist die Meßbrücke als Richtkoppler oder als resistive Brücke ausgebildet. Um eine besonders effiziente Auskopplung des Referenz- und Meßsignals über einen vergleichsweise großen Frequenzbereich zu erreichen, ist die Meßbrücke als Serienschaltung eines Richtkopplers und einer resistiven Brücke ausgebildet.

Gemäß einer vorteilhafter Ausgestaltung weist der Netzwerkanalysator eine Schaltereinrichtung auf, welche dem Signalgenerator nachgeschaltet ist und womit das vom Signalgenerator erzeugte Anregungssignal dem Eingangstor des Meßobjekts oder dem Ausgangstor des Meßobjekts zuführbar ist.

Die mit der Erfindung erzielten Vorteile bestehen insbesondere darin, dass der Dynamikbereich eines Netzwerkanalysators besonders vergrößert wird. Damit ist, wie im vorhergehenden Beispiel erläutert, eine Transmission eines besonders kleinen Anteils des Anregungssignals durch das Meßobjekt meßbar.

Des Weiteren kann ein Netzwerkanalysator mit einem Meßzweig und einem Referenzzweig kostengünstig durch Einbau von Dämpfungsgliedern und/oder verstellbaren Verstärkern zur Durchführung des erfindungsgemäßen Verfahrens realisiert werden. Für den Fall, dass lediglich der Referenzsignalpegel oder der Meßsignalpegel verändert wird, kann bei Berechnung des gewünschten Torparameters eine Pegeländerung in besonders einfacher Weise über die Dämpfung berücksichtigt werden.

Nachfolgend werden Ausführungsbeispiele der Erfindung anhand einer Zeichnung erläutert. Darin zeigen:
- Fig. 1: ein Prinzipschaltbild eines Netzwerkanalysators mit einem an diesem angeschlossenen Meßobjekt in einem ersten Ausführungsbeispiel;
- Fig. 2: ein Prinzipschaltbild eines Netzwerkanalysators mit einem an diesem angeschlossenen Meßobjekt in einem zweiten Ausführungsbeispiel und
- Fig. 3: einen Verlauf eines Vorwärtsübertragungsfaktors s₂₁ eines als Bandpaß ausgeführten Meßobjekts über der Frequenz.

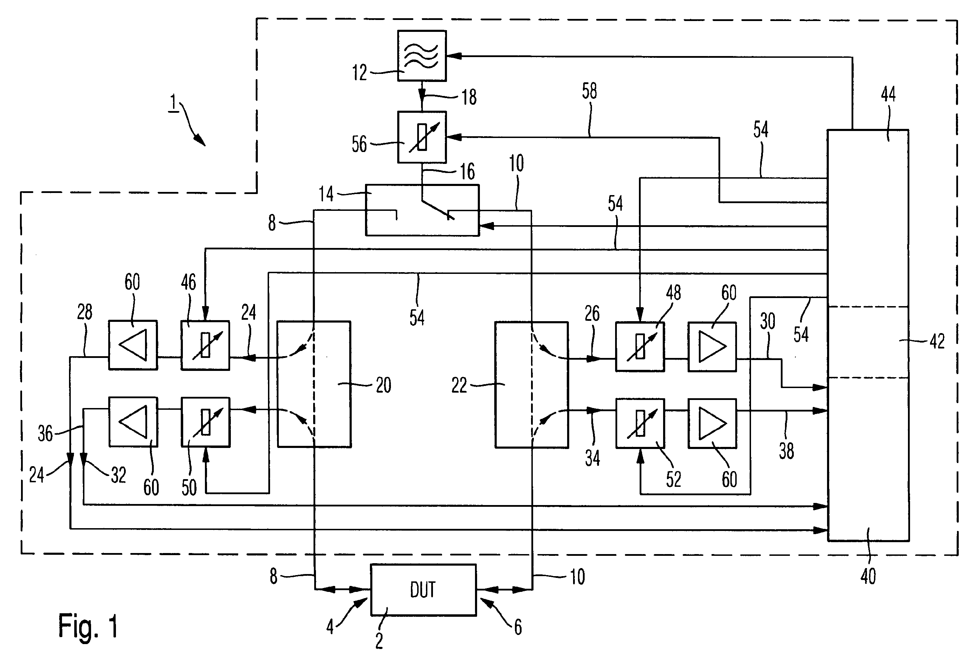

In Fig. 1 ist ein Prinzipschaltbild eines Netzwerkanalysators 1 gezeigt. An den Netzwerkanalysator 1 ist ein Meßobjekt 2 mit einem Eingangstor 4 und einem Ausgangstor 6 über Meßleitungen 8 und 10 angeschlossen. Der Netzwerkanalysator 1 umfasst einen Signalgenerator 12 sowie eine beispielsweise als elektromechanischer Schalter ausgebildete Schaltereinrichtung 14, worüber ein vom Signalgenerator 12 erzeugtes und auf der Signalleitung 16 zur Verfügung gestelltes Anregungssignal 18 entweder auf die zum Eingangstor 4 führende Meßleitung 8 oder auf die zum Ausgangstor 6 führende Meßleitung 10 geschaltet ist.

Der Netzwerkanalysator 1 weist weiterhin mit den Meßleitungen 8 und 10 signalverbundene Meßbrücken 20 bzw. 22 auf. Über die Meßbrücken 20,22 wird ein Referenzsignal 24,26, welches dem Anregungssignal 18 entspricht, auf jeweils einen Referenzzweig 28,30 und ein Meßsignal 32,34, welches einem vom Meßobjekt 2 rücklaufenden Signal entspricht, auf jeweils einen Meßzweig 36,38 ausgekoppelt. Die Referenzzweige 28,30 und die Meßzweige 36,38 sind mit einem A/D-Wandler 40, welchem das Referenzsignal 24,26 und das Meßsignal 32,34 zugeführt werden, signalverbunden. Der A/D-Wandler 40 ist auch mit einer Auswerteeinrichtung 42 signalverbunden, welche einen Referenzsignalpegel des Referenzsignals 24,26 und einen Meßsignalpegel des Meßsignals 32,34 erfaßt.

Zudem weist der Netzwerkanalysator 1 in den Referenzzweigen 28,30 und in den Meßzweigen 36,38 angeordnete und als Dämpfungsglieder ausgebildete Stellglieder 46,48,50,52 auf, welche über Steuerleitungen 54 mit einer Steuereinrichtung 44 signalverbunden und von dieser einstellbar sind. Die Auswerteeinrichtung 42 ist mit der Steuereinrichtung 44 signalverbunden und stellt dieser den Referenzsignalpegel und den Meßsignalpegel zur Verfügung. Zusätzlich weist der Netzwerkanalysator 1 ein zwischen den Signalgenerator 12 und die Schaltereinrichtung 14 geschaltetes Stellglied 56 auf, welches über eine Steuerleitung 58 mit der Steuereinrichtung 44 signalverbunden und von dieser einstellbar ist. Ferner weist der Netzwerkanalysator 1 in den Referenzzweigen 28,30 und in den Meßzweigen 36,38 angeordnete Verstärker 60 auf, welche in diesem Ausführungsbeispiel als nicht verstellbare Verstärker 60 ausgebildet sind.

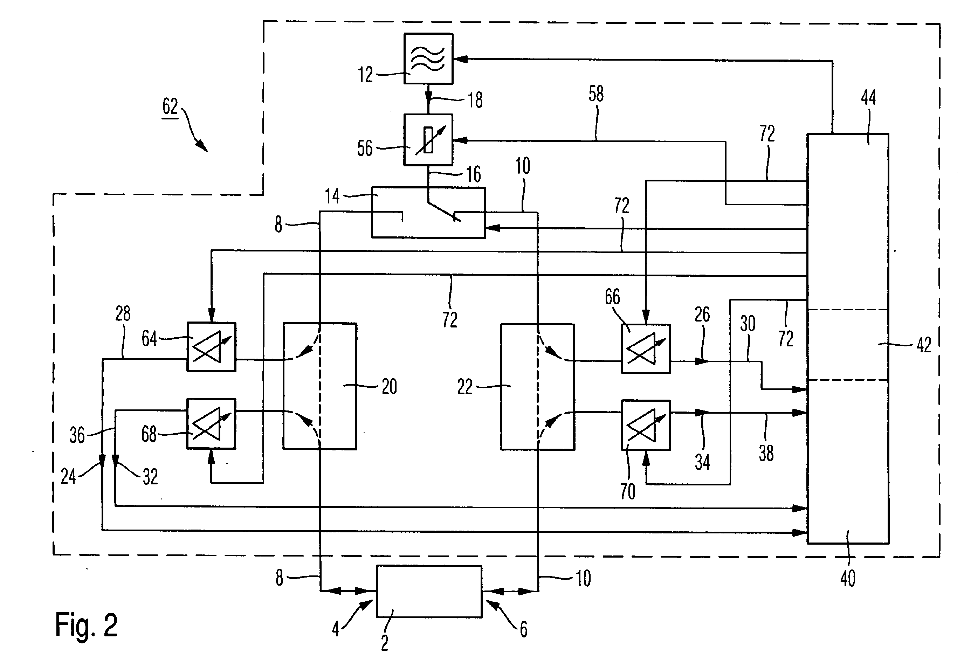

Fig. 2 zeigt ein Prinzipschaltbild eines Netzwerkanalysators 62, welches sich lediglich von dem in Fig. 1 gezeigten Netzwerkanalysator 1 dadurch unterscheidet, dass die Referenzzweige 28,30 und die Meßzweige 36,38 keine als Dämpfungsglieder ausgebildete Stellglieder 46,48,50,52, sondern verstellbare Verstärker 64,66,68,70 aufweisen. Die Verstärker 64,66, 68,70 sind über Steuerleitungen 72 mit der Steuereinrichtung 44 signalverbunden und von dieser einstellbar.

Das vom Netzwerkanalysator 1,62 erzeugte Anregungssignal 18 wird zur Analyse des Meßobjekts 2 diesem über die Signalleitung 16 und die Meßleitung 8 oder die Meßleitung 10 zugeführt. Um beispielsweise die Torparameter "Eingangsreflexionsfaktor s₁₁" und "Vorwärtsübertragungsfaktor s₂₁" zu ermitteln, ist die Schaltereinrichtung 14 derart geschaltet, dass das Anregungssignal 18 über die Meßleitung 8 dem Eingangstor 4 des Meßobjekts 2 zugeführt wird. Um beispielsweise die Torparameter "Ausgangsreflexionsfaktor S₂₂" und "Rückwärtsübertragungsfaktor S₁₂" zu ermitteln, ist die Schaltereinrichtung 14 derart geschaltet, dass das Anregungssignal 18 über die Meßleitung 10 dem Ausgangstor 6 des Meßobjekts 2 zugeführt wird.

Zur Ermittlung des Eingangsreflexionsfaktors S₁₁ wird der Signalgenerator 12 veranlaßt, zur Erzeugung der Frequenz des Anregungssignals 18 einen vorgegebenen Frequenzbereich zu durchfahren (Sweep). Die Schaltereinrichtung 14 ist derart geschaltet, dass das Anregungssignal 18 über die Meßleitung 8 auf das Eingangstor 4 des Meßobjekts 2 zuläuft. Weiterhin wird dem A/D-Wandler 40 das dem Anregungssignal 18 entsprechende Referenzsignal 24, welches an der Meßbrücke 20 ausgekoppelt wird, über den Referenzzweig 28 und das am Meßobjekt 2 reflektierte und rücklaufende Meßsignal 32, welches auch an der Meßbrücke 20 ausgekoppelt wird, über den Meßzweig 36 zugeführt. Der Eingangsreflexionsfaktors s₁₁ ergibt sich also aus einer am Eingangstor 4 des Meßobjekts 2 einfallenden Welle a₁ und aus einer vom Eingangstor 4 des Meßobjekts 2 rücklaufenden Welle b₁.

Aus den über das Referenzsignal 24 und das Meßsignal 32 ermittelten Meßwerten kann somit der Eingangsreflexionsfaktors s₁₁ = b₁ / a₁ ermittelt werden.

Die mit dem A/D-Wandler 40 signalverbundene Auswerteeinrichtung 42 erfaßt bei jeder gewünschten Frequenz im vom Signalgenerator 12 zu durchfahrenden Frequenzbereich einen Referenzsignalpegel des Referenzsignals 24 und einen Meßsignalpegel des Meßsignals 32. Die mit der Auswerteeinrichtung 42 signalverbundene Steuereinrichtung 44 steuert die Stellglieder 46,48,50,52,56 oder verstellbaren Verstärker 64,66,68,70 zur Einstellung des jeweiligen Signalpegels über Steuerleitungen 54,58,72 an. Die Steuereinrichtung 44 führt die Einstellung der Stellglieder 46,48,50,52,56 oder der verstellbaren Verstärker 64,66,68,70 bei jeder gewünschten Frequenz solange fort, bis der jeweilige von der Auswerteeinrichtung 42 erfaßte Signalpegel in einem Pegelbereich zwischen einer spezifischen oder beliebig vorgegebenen Pegelobergrenze und/oder einer spezifischen oder beliebig vorgegebenen Pegeluntergrenze liegt.

Wie bereits in der Beschreibungseinleitung erläutert, zeigt Fig. 3 den Verlauf des Vorwärtsübertragungsfaktors s₂₁ eines als Bandpaß ausgeführten Meßobjekts über der Frequenz. Dabei beschreibt der Vorwärtsübertragungsfaktor s₂₁ ein Verhältnis von der am Ausgang des Meßobjekts austretenden Welle b₂ zu der am Eingang des Meßobjekts einfallenden Welle a₁, wobei das Meßobjekt im Frequenzbereich B einen Durchlaßbereich und in den Frequenzbereichen A und C Sperrbereiche aufweist. Im Sperrbereich wird ein vergleichsweise großer Anteil der einfallenden Welle a₁ am Eingang des Meßobjekts reflektiert. Im Gegensatz dazu transmittiert im Durchlaßbereich ein großer Anteil der einfallenden Welle a₁ durch das Meßobjekt.

Mit Hilfe des in den Ausführungsbeispielen beschriebenen Verfahrens und der zur Durchführung des Verfahrens geeigneten Netzwerkanalysatoren ist es zum einen möglich, Übergänge zwischen den Durchlaß- und Sperrbereichen besonders exakt zu ermitteln. Zum anderen ist der Dynamikbereich des erfindungsgemäßen Netzwerkanalysators besonders groß, da der Bereich, in welchem die Transmission meßbar ist, vergleichsweise groß ist. So ist mit dem erfindungsgemäßen Netzwerkanalysator möglich, den vergleichsweise minimalen Anteil der am Eingang in das Meßobjekt eingefallenen und durch dieses transmittierten Welle bei einer Frequenz im Sperrbereich des Meßobjekts vom Eigenrauschen des Netzwerkanalysators zu unterscheiden und zu messen.

## Patentansprüche

1. Verfahren zum Regeln eines Signalpegels eines Signals an einem Netzwerkanalysator (1;62), womit ein Anregungssignal (18) zum Analysieren eines am Netzwerkanalysator (1;62) anschließbaren Meßobjekts (2) erzeugt wird, bei welchem
ein dem Anregungssignal (18) entsprechendes Referenzsignal (24,26) auf einen Referenzzweig (28,30) ausgekoppelt und ein Referenzsignalpegel des Referenzsignals (24,26) ermittelt wird und/oder
ein vom Meßobjekt (2) rücklaufendes Meßsignal (32,34) auf einen Meßzweig (36,38) ausgekoppelt und ein Meßsignalpegel des Meßsignals (32,34) ermittelt wird
und bei Überschreiten einer spezifischen Pegelobergrenze und/oder bei Unterschreiten einer spezifischen Pegeluntergrenze erniedrigt bzw. erhöht wird.

2. Verfahren nach Anspruch 1,
**dadurch gekennzeichnet,**
**daß** der Referenzsignalpegel mittels eines im Referenzzweig (28,30) angeordneten Referenzzweigstellglieds (46,48;64,66) eingestellt wird.

3. Verfahren nach Anspruch 1 oder 2,
**dadurch gekennzeichnet,**
**daß** der Meßsignalpegel mittels eines im Meßzweig (36,38) angeordneten Meßzweigstellglieds (50,52;68,70) eingestellt wird.

4. Verfahren nach einem der Ansprüche 1 bis 3,
**dadurch gekennzeichnet,**
**daß** ein Anregungssignalpegel des Anregungssignals (18) am Referenzzweig (28,30) und/oder am Meßzweig (36,38) ermittelt und bei Überschreiten einer spezifischen Pegelobergrenze und/oder bei Unterschreiten einer spezifischen Pegeluntergrenze erniedrigt bzw. erhöht wird.

5. Verfahren nach Anspruch 4,
**dadurch gekennzeichnet,**
**daß** der Anregungssignalpegel des Anregungssignals (18) mittels eines dem Signalgenerator (12) nachgeschalteten Generatorstellglied (56) eingestellt wird.

6. Verfahren nach einem der Ansprüche 1 bis 5,
**dadurch gekennzeichnet,**
**daß** bei der Ermittlung von Meßparametern und Torparametern des Meßobjekts (2) für die Analyse des Meßobjekts (2) aus am Meßzweig (36,38) und/oder am Referenzzweig (28,30) erfaßten Meßwerten des Referenzsignals (24,26) bzw. des Meßsignals (32,34) eine Änderung des Referenzsignalpegels und/oder des Meßsignalpegels berücksichtigt wird.

7. Netzwerkanalysator (1;62) umfassend
einen Signalgenerator (12) zum Erzeugen eines Anregungssignals (18), welches über eine Meßleitung (8,10) einem am Netzwerkanalysator (1;62) anschließbaren Meßobjekt (2) zuführbar ist, wobei ein dem Anregungssignal (18) entsprechendes Referenzsignal (24,26) über eine an der Meßleitung (8,10) angeordnete Meßbrücke (20,22) auf einen Referenzzweig (28,30) und ein auf der Meßleitung (8,10) vom Meßobjekt (2) rücklaufendes Meßsignal (32,34) über die Meßbrücke (20,22) auf einen Meßzweig (36,38) auskoppelbar ist,
eine mit dem Referenzzweig (28,30) und dem Meßzweig (36,38) signalverbundene Auswerteeinrichtung (42) zur Erfassung eines Referenzsignalpegels des Referenzsignals (24,26) und/oder eines Meßsignalpegels des Meßsignals (32,34) und
eine mit der Auswerteeinrichtung (42) signalverbundene Steuereinrichtung (44) zur Einstellung einer Dämpfung und/oder Verstärkung des Referenzsignals (24,26) an einem im Referenzzweig (28,30) vorgesehenen Stellglied (46,48;64,66) und/oder des Meßsignals (32,34) an einem an einem im Meßzweig (36,38) vorgesehenen Stellglied (50,52;68,70).

8. Netzwerkanalysator nach Anspruch 7,
**gekennzeichnet durch**
ein Generatorstellglied (56), welches dem Signalgenerator (12) nachgeschaltet und mit der Steuereinrichtung (44) zur Einstellung eines Anregungssignalpegels signalverbunden ist.

9. Netzwerkanalysator nach Anspruch 7 oder 8,
**dadurch gekennzeichnet,**
**daß** das Stellglied (46,48,50,52;64,66,68,70) als verstellbarer Verstärker (64,66,68,70) und/oder verstellbares Dämpfungsglied (46,48,50,52)ausgebildet ist.

10. Netzwerkanalysator nach Anspruch 7,
**dadurch gekennzeichnet,**
**daß** eine dem Generatorstellglied (56) nachgeschaltete Schaltereinrichtung (14) vorgesehen ist, um das Anregungssignal (18) einem Eingangstor (4) oder einem Ausgangstor (6) des Meßobjekts (2) zuzuführen.
